# EUROPEAN PATENT APPLICATION

(11) **EP 2 282 487 A1**
(43) Date of publication of application: **09.02.2011**
(21) Application number: 10169052.7
(22) Date of filing: 09.07.2010
(51) Int. Cl.: H04M 1/02, H04B 1/38

(54) **Assembly for housing a memory card in an electronic device**

(30) Priority: 09.07.2009 US 224240 P
(71) Applicant: Research In Motion Limited, Waterloo, ON N2L 3W8 (CA)
(72) Inventor: Moskowitz, Douglas Wayne, Sunrise, FL 33323 (US); Ivanik, Bruce Alan, Sunrise, FL 33323 (US)
(74) Representative: Phillips, Emily Elizabeth

(57) **Abstract**

A handheld electronic device (10) includes a housing (12) having a front face (14) and a back face (24), the back face (24) defining an interior compartment (30). A back cover (26) is configured for enclosing the interior compartment (30), the interior compartment (30) further defining a recess (34) configured for receiving a memory card (28). The recess (34) includes a bottom surface (42) arranged substantially parallel to the front face (14) and the back face (24), a pair of oppositely located sidewalls (36), an end wall (38) defining a slot (48) configured for receiving the memory card (28), and a sloped wall (40) provided opposite the end wall (38).

## Description

### FIELD OF TECHNOLOGY

The subject matter herein generally relates to handheld electronic devices, and more specifically relates to an assembly for retaining a memory card within a handheld electronic device.

### BACKGROUND

Handheld electronic devices are well known to both consumers and business persons alike. As technology becomes more advanced, so too do the capabilities of such devices. With the advent of more robust electronic devices, users typically require additional memory capabilities to handle the numerous applications offered by the device, such as music, movie, photo and video applications. To accommodate the memory needed to download such media applications, SD or memory card slots are generally provided in handheld electronic devices, and are configured for receiving corresponding memory cards.

Such memory cards are typically configured to be received in corresponding slots provided in either an interior compartment of the device (typically covered by a battery door, for example) or on a side of the device. However, one issue with such conventional configurations is that if the device is dropped, the memory card can become dislodged, or in some cases, fall out, potentially causing malfunction or even damage to the memory card. Another issue with conventional configurations is that due to space constraints on the mobile device and the desire to maintain a handheld size for the device, the memory card can be difficult to insert into and remove from the corresponding slot.

### BRIEF DESCRIPTION OF THE DRAWINGS

FIG. 1 illustrates a front perspective view of an example handheld electronic device in accordance with the present disclosure;

FIG. 2 illustrates a back perspective view of the handheld electronic device shown in FIG. 1;

FIG. 3 illustrates a back perspective view of the handheld electronic device with a back cover removed;

FIG. 4 illustrates a close-up and partial view of an interior portion of the handheld electronic device shown in FIG. 3;

FIG. 5 illustrates a side view of a cross-section of the handheld electronic device taken along cutting line 5-5 of FIG. 3 with the back cover attached;

FIG. 6 illustrates a close-up and partial view of the handheld electronic device shown within area F6 of FIG. 5; and

FIG. 7 is a cross sectional view taken along cutting line 5-5 of FIG. 3 illustrating use of the device.

### DETAILED DESCRIPTION

It will be appreciated that for simplicity and clarity of illustration, where appropriate, reference numerals have been repeated among the different figures to indicate corresponding or analogous elements. In addition, numerous specific details are set forth in order to provide a thorough understanding of the embodiments described herein. However, it will be understood by those of ordinary skill in the art that the embodiments described herein can be practiced without these specific details. In other instances, methods, procedures and components have not been described in detail so as not to obscure the related relevant feature being described. Also, the description is not to be considered as limiting the scope of the embodiments described herein.

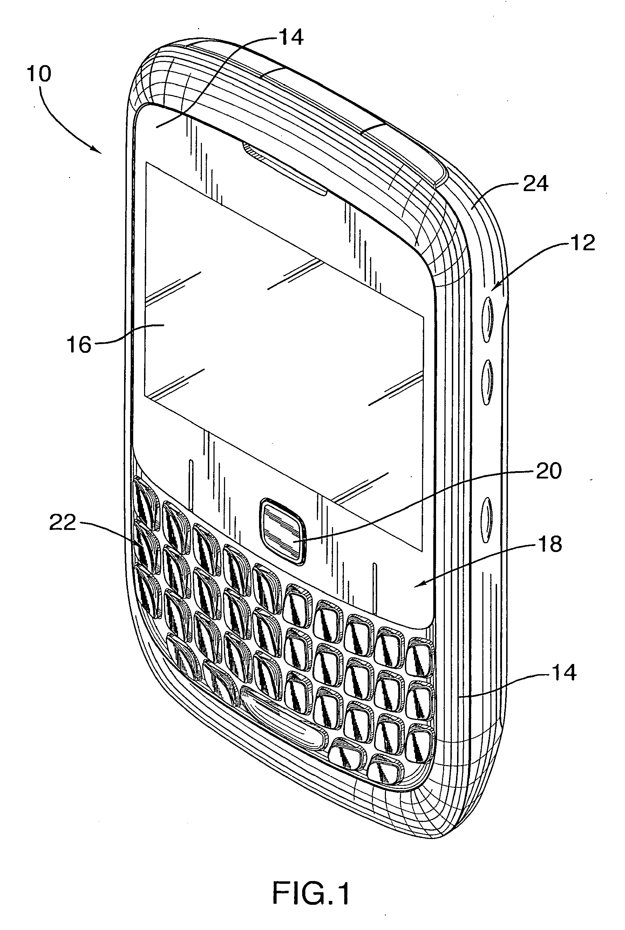

Referring to FIG. 1, an example of a handheld electronic device 10 in accordance with the present disclosure is shown. The handheld electronic device 10 can include a housing 12 that protects the internal components of the device, such as a microprocessor, printed circuit board and other components (not shown), as known in the art. A front face 14 of the device 10 includes a display 16, a navigation key panel 18, a navigation device (such as an optical navigation module, as shown, or a trackball, trackpad, or joystick, for example) 20, and a keyboard 22, which can include a plurality of keys arranged in a keyboard layout and having character indicia thereon. The keyboard 22 can be a physical keyboard with actuatable keys, as shown, or it can be a virtual keyboard presented on a touch screen display. It is appreciated that the device 10 can include additional or fewer external components, such as side buttons, a camera, a USB port, and the like, and the device 10 is not limited to the features disclosed herein. It will also be understood that the components required for mobile communication device operation are not fully shown in Figure 1 or described herein as they are not material to the understanding of the method and apparatus for providing an assembly for housing a memory card for a mobile communication device.

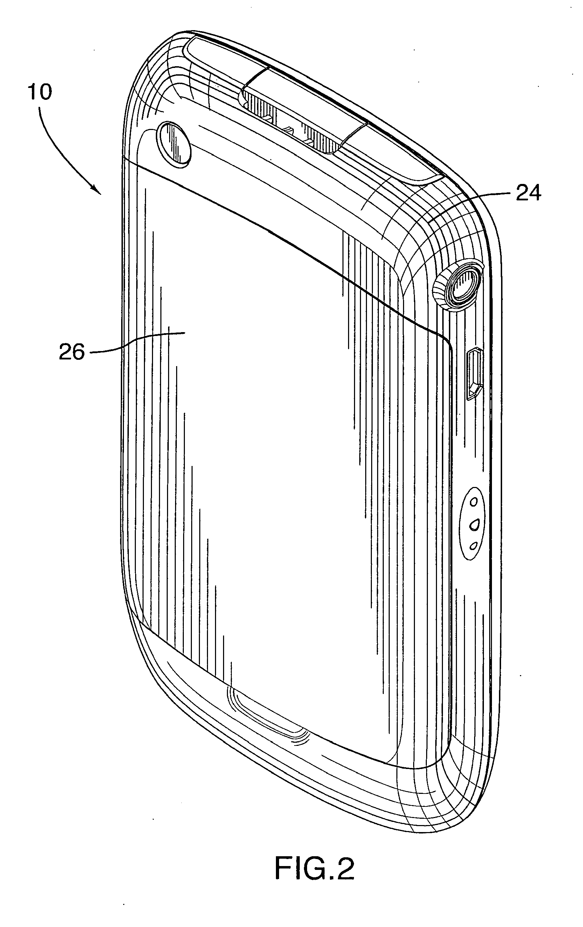

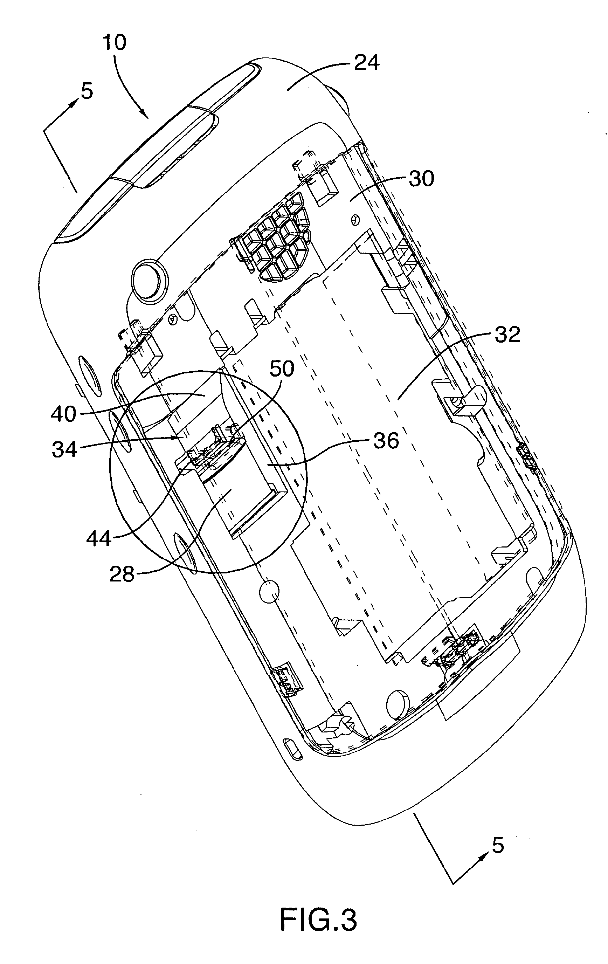

Turning now to FIGs. 2 and 3, a back face 24 of the device 10 includes a back cover or battery door 26 configured to enclose a battery (not shown) and a memory card 28 (FIG. 3) of the device. The back cover 26 is removably attached to the back face 24 by a plurality of hooks/tabs and mating or inter-fitting corresponding notches/openings. More specifically, the back cover 26 is preferably "snap-fit" into the back face 24, although it is appreciated that alternative structures for securing the back cover to the back face may be appropriate, such as a rail/groove structure or a tab/slot structure, for example. The back face 24 defines an interior compartment 30 including a well 32 configured for retaining the battery (not shown). When the battery is received in the well 32, the top surface of the battery is substantially flush with the interior compartment 30, although the present disclosure is not limited to such a configuration.

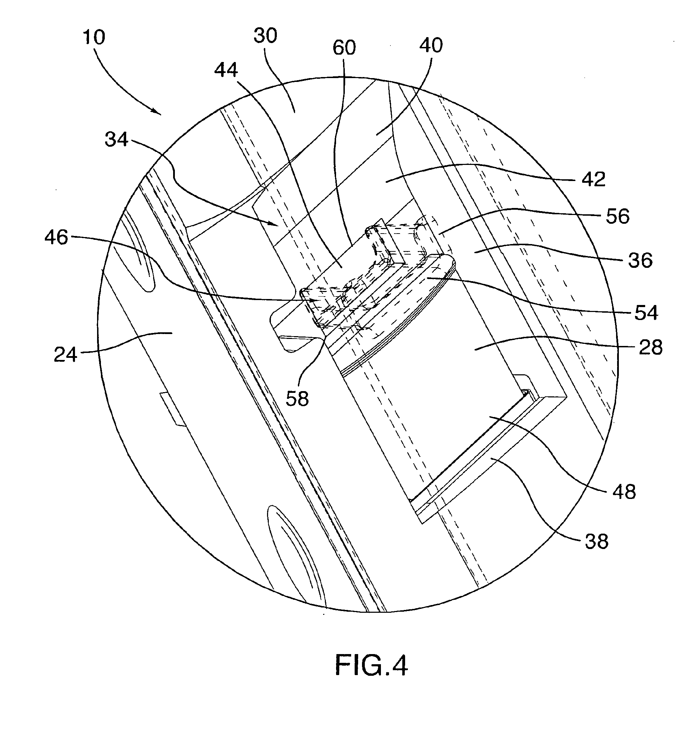

Referring next to FIGs. 3 and 4, disposed within the interior compartment 30 is a recess 34 to receive a memory card 28. The recess 34 is defined by a pair of oppositely located sidewalls 36, an end wall 38, a sloped wall or ramp 40 located opposite the end wall and a substantially flat bottom surface 42 that is arranged substantially parallel to one or both of the front and back faces 14, 24, respectively, of the device 10. As best seen in FIG. 4, the sloped wall 40 may be slightly curved and is sloped at an angle relative to the bottom surface 42. Although other ranges may be appropriate, the sloped wall is preferably arranged at an angle between 40°-70° relative to the bottom surface 42. The sloped wall aids in manual insertion and removal of a memory card into and from the recess 34.

In some embodiments, the bottom surface 42 forms a window 44 provided adjacent to the sloped wall 40. The window 44 may take a rectangular configuration, although it is appreciated that the window is not limited to a rectangular configuration. As will be described in further detail below, the window 44 is configured to receive a corresponding stop 46 protruding from the back cover 26. The configuration of the recess 34 and the back cover stop 46 provide an assembly to receive and retain or house the memory card 28, as will be described in further detail below.

As best shown in FIG. 4, the end wall 38 is arranged substantially perpendicular to the bottom surface 42, and further includes a slot 48 configured for receiving the memory card 28. The slot 48 is dimensioned to receive the memory card 28 such that when the card is fully engaged in the slot, a portion of the card remains outside of the slot and rests on or near the bottom surface 42. More specifically, when the memory card 28 is engaged in the slot 48, an external end 50 (FIG. 3) of the memory card extends along the length of the bottom surface 42 proximal to the window 44.

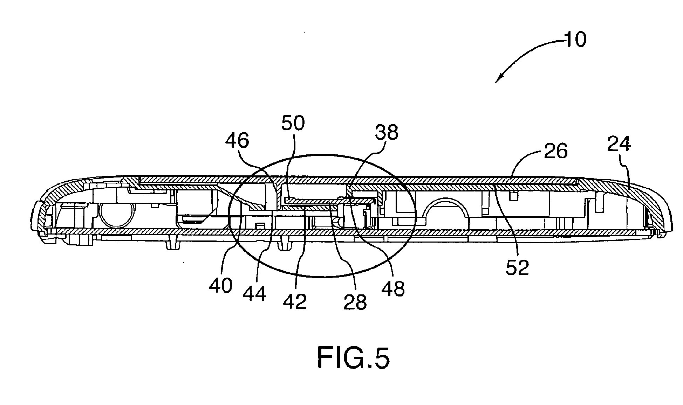

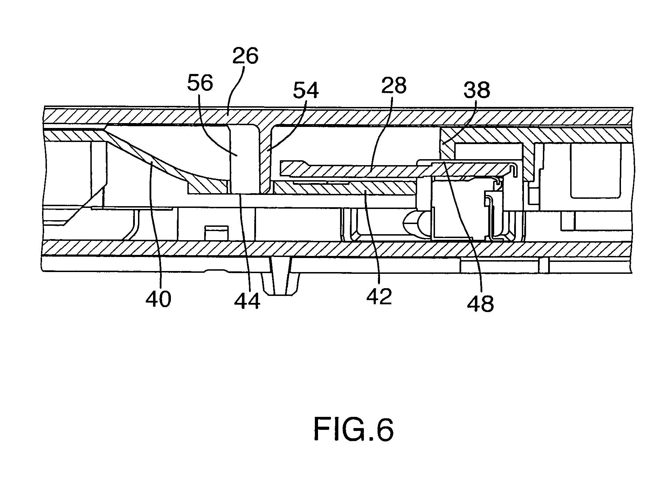

FIGs. 5 and 6 illustrate cross-sectional views of the device 10 taken along cutting line 5-5 of Figure 3, where Figure 6 is a close-up view of the portion circled F6 of Figure 5. In Figures 5 and 6 the device 10 is depicted with the back cover 26 in-place and with the memory card 28 received in the slot 48 where the back cover 26 is secured to the back face 24 of the device 10. As briefly described above, the back cover 26 includes the stop 46 to retain memory card 28 within the slot 48 when the back cover 26 is secured to the device 10. The stop 46 protrudes from an interior surface 52 of the back cover. In some embodiments, stop 46 protrudes substantially perpendicularly from the interior surface 52 of the back cover 26 and may be integrally formed with the back cover, for example, where both the back cover and the stop are a manufactured article, such as, by injection molding from a thermoplastic or other resilient material. In the stop construction shown in FIG. 4, the stop 46 is formed having a U-shaped cross-section profile with a base portion 54 and a pair of oppositely located side arms 56 extending outwardly from the base portion on a side of the stop opposite that of a side proximal to the memory card 28. Although other thicknesses may be appropriate, the base portion 54 is approximately 0.6-0.8 mm thick, and in some constructions, is approximately 0.78 mm in thickness. However, it will be appreciated that the stop 46 may have other suitable constructions and configurations and is not limited to those described herein.

In some implementations, when the back cover 26 is secured to the back face 24 of the device 10, the stop 46 is configured to be received within the window 44. More specifically, the stop 46 is configured to be received within the window 44 such that the base portion 54 of the stop is adjacent to a first end or wall 58 (FIG. 4) of the window 44, where the first end is located proximal to the memory card 28. Further, when the stop 46 is received within the window 44, the side arms 56 of the stop extend up to a second end or wall 60 (FIG. 4) of the window, where the second end is located distal (i.e., away) from the memory card 28 and opposite from the first end 58.

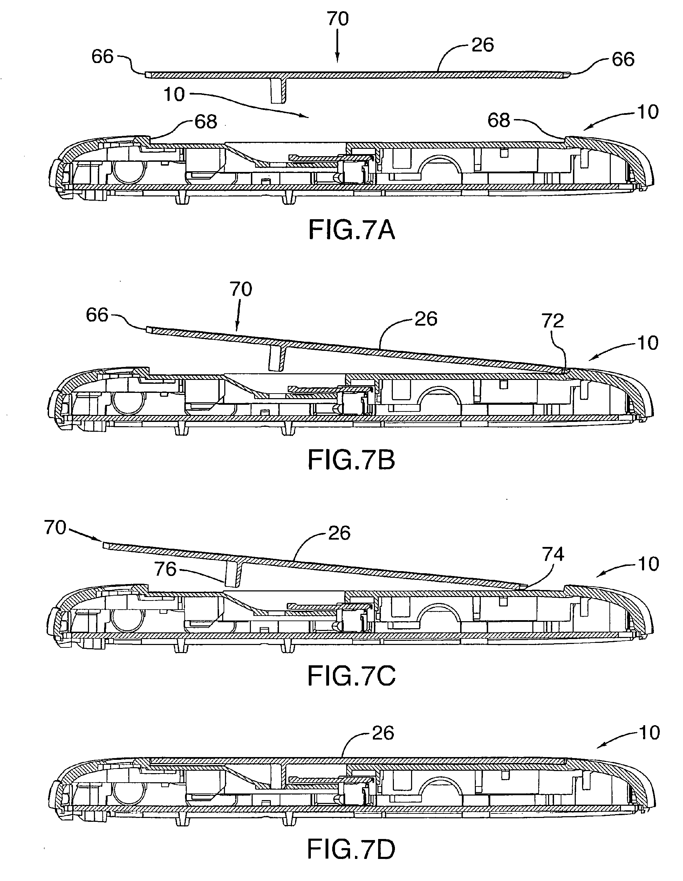

When the user wishes to insert the memory card 28 into the device 10, the back cover 26 is removed, exposing the interior compartment 30. The user then properly orients the memory card 28 to be received in the slot 48, slides the card down the sloped wall 40, along the bottom surface 42 and finally into the slot. When the memory card 28 is fully received in the slot 48, the back cover 26 can then be secured to the back face 24 of the device 10 and examples of this are shown in and described with reference to Figure 7. The slot 48 may click or lock into the slot by a biasing member or an inter-fitting snap-fit construction.

Reference is made now to Figure 7, which is a cross sectional view taken along cutting line 5-5 of FIG. 3 showing various ways in which back cover 26 may be operated to attach it to device 10. It will be understood that the particular method of operating back cover 26 to attach it to device 10 may depend on a particular selected configuration of an attachment mechanism to releasably attach back cover 26 to device 10. Although other structures for attachment may be suitable, to attach the back cover 26 to the device 10 in some constructions, top hooks or tabs 66 are provided on the back cover 26, which the user inserts into corresponding mating opening or notches 68 formed in the back face or interior compartment 30 of device 10. The user then rotates the back cover about a hinge point 72 in a downward direction, as generally shown by arrows 70, such that another hook or tab 66 at the another end of the back cover is received in a corresponding mating opening or notch or notches 68 provided in the device 10, and snaps the back cover 26 securely onto the back face 24 to enclose the interior compartment 30 and obtain a completed closed configuration, which is shown in Figure 7(d). In another manner of operation to attach the back cover 26 to the back face 24, which is shown in Fig, 7(c), the user slides the back cover along sliding contact points 74, 76 in the general direction of arrow 70 and snaps the back cover 26 securely into the device 10 to obtain the completed closed configuration also shown in Figure 7(d).

When the back cover 26 is properly secured to the back face 24, the interior compartment 30 is substantially entirely enclosed by the back cover, and the stop 46 is received within the window 44 (FIG. 6). In some constructions, when the back cover 26 is secured to the back face 24 and the memory card 28 is fully received in the slot 48, the external end 50 of the memory card is approximately between 0.2-0.3 mm away from the base portion 54 of the stop, although other distances may be suitable. The stop 46 is configured to further secure and retain the memory card 28 within the slot 48, especially in instances where the device is dropped or jostled during operation, for example. Specifically, if the user drops the device, when the device hits the ground or other solid surface, the back cover 26 is configured to flex or move a slight distance to reduce shock. In conventional devices, when such a drop occurs, the memory card may be dislodged from its slot, causing the potential for malfunction or even damage to the memory card. However, in some configurations, when such a drop occurs, the memory card 28 will remain securely in place within the slot 48 and corresponding recess 34, because the stop 46 prevents lateral movement (i.e., movement out of the slot 48) of the memory card 28. Specifically, when the back cover 26 flexes or moves upon dropping of the device 10, although some slight movement is possible to reduce shock, the stop 46 is retained within the window 44 by the first and second walls 58, 60 of the window, preventing the memory card 28 from being ejected from the slot 48. Accordingly, it is contemplated that the present configuration of the stop 46 securely retains the memory card 28 within the slot 48 and recess 34, and also prevents damage from occurring to the memory card if the device 10 is dropped.

To remove the memory card 28 from the device 10, the user first removes the back cover 26 from the back face 24, exposing the interior compartment 30. Next, the user, utilizing a finger, for example, pulls the memory card 28 from the slot 48 by sliding the card along the bottom surface 42 and up the sloped wall 40. It is contemplated that the configuration of the recess 34 and the slot 48 enables the user to easily remove the memory card 28 in comparison to conventional memory card housings, which typically include a slot adjacent to a recess having a flat or planar surface. Such flat or planar surfaces can render it difficult to remove the memory card from the slot if the user does not have relatively small fingers or a small, pointed object to pry the card up and away from the recess. By providing the sloped wall 40 adjacent to the bottom surface 42, the user can simply use their finger to slide the memory card 28 out of the slot and along the sloped wall to fully remove the card from the device 10. It is further contemplated that the present configuration of the recess 34 does not increase the overall shape of the device 10, but rather utilizes existing surface area provided in the interior compartment 30.

In at least one embodiment of the present disclosure is a handheld electronic device having a recess. The recess is formed by a pair of oppositely located sidewalls; a substantially flat bottom surface arranged substantially parallel to a back face of the device; an end wall arranged substantially perpendicular to the bottom surface; a slot defined in the end wall, the slot configured for receiving a memory card; and a sloped wall provided opposite the end wall. In at least one embodiment, the bottom surface further forms a window. The window can be formed by the bottom surface including a first end adjacent to the end wall, and a second end adjacent to the sloped wall. In at least one embodiment, the window is substantially rectangular in shape. Additionally, the window can be configured to receive a stop protruding from a back cover of the device, the stop configured for retaining the memory card in the slot and within the recess. The stop can protrude substantially perpendicular to an interior surface of the back cover. In another embodiment, the stop is substantially U-shaped and includes a base portion and a pair of side arms extending substantially perpendicular to the base portion. The base portion can be substantially parallel to the first and second ends of the window.

In another embodiment, a handheld according to the present disclosure can include a housing, a back cover and a stop. The housing forms an opening to an interior compartment having a recess configured for receiving a memory card. The back cover can be dimensioned to releasably engage the housing to cover the opening and enclose the interior compartment. The stop can extend from the back cover to secure the memory card in the recess when the back cover is engaged with the housing. The back cover and housing can respectively include at least one tab and at least one mating notch to releasably engage each other. The at least one tab is provided on the back cover and a respective notch is formed in the housing. In another embodiment, the at least one tab is provided on the housing and a respective notice is formed in the back cover. In at least one embodiment, the stop can be substantially U-shaped. Additionally the housing can further provide a window in the recess. The window can be configured for receiving the stop when the back cover is engaged with the housing.

The present disclosure provides an assembly for housing a memory card in a handheld electronic device that enables the user to easily insert and remove the card, due to the configuration of the recess having both a substantially flat bottom surface and an adjacent sloped wall. Further, the present assembly includes a back cover having a stop protruding therefrom that is configured for securely retaining the memory card within the recess and further for preventing damage to the memory card when the device is dropped. It should be appreciated that the present assembly (i.e., the configuration of the recess and the back cover stop) is not limited to retaining a memory card in a handheld electronic device. Rather, it may be appreciated that the back cover stop could similarly be utilized to retain a battery or a SIM card within the interior compartment, and that the recess having the sloped wall could similarly be used to increase the ease of insertion and removal of the battery or the SIM card from the interior compartment. It is further appreciated that the recess and back cover stop described herein could be used in other fields, such as remote control devices, other personal communication devices, and the like.

While particular features and embodiments of an assembly for housing a memory card in a handheld electronic device have been described herein, it will be appreciated by those skilled in the art that changes and modifications may be made thereto without departing from aspects within the scope of the claims as set forth below.

## Claims

1. A handheld electronic device (10), comprising:
a housing (12) defining an interior compartment (30) on a back face (24) that includes a structure forming recess (34) configured to receive a memory card (28), said structure comprising:
a bottom surface (42) arranged substantially parallel to said back face (24);
a pair of oppositely located sidewalls (36);
an end wall (38) defining a slot (48) configured for receiving the memory card (28);
a sloped wall (40) provided opposite said end wall (38); and
a back cover (26) configured to releasably engage the housing (12) to enclose the interior compartment (30).

2. The handheld electronic device (10) of claim 1 further including:
a display (16) provided in a front face (14) of the device (10); and
a keyboard (22) provided in the front face (14) and located below said display (16).

3. The handheld electronic device (10) of claims 1 or 2 wherein said back cover (26) includes a stop (46) protruding therefrom to secure a memory card (28) received in the recess (34).

4. The handheld electronic device (10) of claim 3 wherein said stop (46) is arranged substantially perpendicular to the back cover (26).

5. The handheld electronic device (10) of claims 3 or 4 wherein said stop (46) is substantially U-shaped.

6. The handheld electronic device (10) of any one of claims 3-5 wherein said bottom surface (42) defines a window (44) configured for receiving said stop (46).

7. The handheld electronic device (10) of claim 6 wherein said window (44) is substantially rectangular in shape.

8. The handheld electronic device (10) of claims 6 or 7 wherein said window (44) is provided on said bottom surface (42) and adjacent to said sloped wall (40).

9. A back cover (26) for a handheld electronic device (10) comprising:
an interior surface (52) configured to enclose an interior compartment (30) of the device (10) when the back cover (26) is attached to the device (10); and
a stop (46) protruding from the interior surface (52), wherein the stop (46) is configured for retaining a memory card (28) within a recess (34) defined in the interior compartment (30).

10. The back cover (26) of claim 9, wherein the stop (46) is arranged substantially perpendicular to the interior surface (52).

11. The back cover (26) of claims 9 or 10, wherein the stop (46) is substantially U-shaped.

12. The back cover (26) of any one of claims 9-11 wherein the stop (46) is configured to be received in a window (44) defined in a bottom surface (42) of the recess (34).

13. A handheld electronic device (10) having a recess (34) formed by:
a pair of oppositely located sidewalls (36);
a substantially flat bottom surface (42) arranged substantially parallel to a back face (24) of the device (10);
an end wall (38) arranged substantially perpendicular to said bottom surface (42);
a slot (48) defined in said end wall (38), said slot (48) configured for receiving a memory card (28); and
a sloped wall (40) provided opposite said end wall (38).

14. A handheld electronic device (10), comprising:
a housing (12) forming an opening to an interior compartment (30) having a recess (34) configured for receiving a memory card (28);
a back cover (26) dimensioned to releasably engage the housing (12) to cover the opening and enclose the interior compartment (30), and
a stop (46) extending from the back cover (26) to secure a memory card (28) in said recess (34) when the back cover (26) is engaged with the housing (12).
